# EUROPEAN PATENT SPECIFICATION

(11) **EP 4 465 359 B1**
(45) Date of publication and mention of the grant of the patent: **28.10.2026**
(21) Application number: 24204533.4
(22) Date of filing: 16.07.2019
(51) Int. Cl.: H03K 17/94, G01S 7/4861, G01S 17/08, H10F 39/00, G01S 17/894

(54) **HIGH-SENSITIVITY DEPTH SENSOR WITH NON-AVALANCHE PHOTODETECTOR AND METHOD FOR OPERATING THE SAME**
HOCHEMPFINDLICHER TIEFENSENSOR MIT NICHT-AVALANCHE-FOTODETEKTOR UND VERFAHREN ZUM BETRIEB DAVON
CAPTEUR DE PROFONDEUR À HAUTE SENSIBILITÉ AVEC PHOTODÉTECTEUR NON-AVALANCHÉ ET SON PROCÉDÉ DE FONCTIONNEMENT

(30) Priority: 16.07.2018 US 201862698805 P
(43) Date of publication of application: 20.11.2024
(62) Document number(s) of the earlier application(s) in accordance with Art. 76 EPC: 19746388.8 / 3 824 553
(73) Proprietor: Gigajot Technology, Inc., Pasadena, CA 91107 (US)
(72) Inventor: MASOODIAN, Saleh, Pasadena, 91107 (US); MA, Jiaju, Pasadena, 91107 (US)
(74) Representative: Pellegrini, Marie Claude

(56) References cited:
- US-A1- 2004 021 057
- US-A1- 2011 202 310
- US-A1- 2016 099 283
- US-B2- 8 686 367
- FOSSUM ERIC R ET AL: "A Review of the Pinned Photodiode for CCD and CMOS Image Sensors", IEEE JOURNAL OF THE ELECTRON DEVICES SOCIETY, IEEE, USA, vol. 2, no. 3, 1 May 2014 (2014-05-01), pages 33 - 43, XP011546236, DOI: 10.1109/JEDS.2014.2306412

## Description

### CROSS-REFERENCE TO RELATED APPLICATIONS

This application hereby claims priority to U.S. provisional application No. 62/698,805 filed July 16, 2018.

### INTRODUCTION

A three-dimensional imager or depth sensor determines the depth in an object or the distance between the sensor and object generally by measuring either the time required for a light pulse (released from a light source near the sensor) to reflect off the object surface and return for detection by the sensor or by measuring envelope attenuation in the reflection of a carrier wave used to modulate a continuous light source (the attenuation being indicative of phase shift of the modulated carrier). In both pulse-based and phase-based sensing systems, the light sensor must be able to sense reflected light and register its magnitude and/or time of arrival with sufficient resolution to meet application accuracy requirements. For example, a light sensor in a pulse-based system intended measure a distance/depth with 5mm accuracy will need to resolve the round-trip flight time of the light pulse to within -33 picoseconds (ps) with sufficient low-light sensitivity to detect a weakly reflected pulse.

Conventional 3D imagers and depth sensors typically employ solid-state light sensors (photodetectors) with electron avalanche gain such as single-photon avalanche diodes (SPADs) and silicon photon multipliers (SiPMs). Although fast and sensitive to single photons, avalanche-gain photodetectors suffer from a number of drawbacks, including high dark current (i.e., noisy), single-electron well capacity, low quantum efficiency (QE), low spatial resolution, low manufacturing yield, etc. Other more robust photodetectors (i.e., having deeper photowells and/or higher QE, spatial resolution and manufacturing yield) have generally been avoided due to impractically long read-out latency. For example, in a sensor having a pinned photodiode (PPD) read-out by photocharge transfer to a floating diffusion node (e.g., as in a conventional four-transistor imaging pixel), the charge-transfer time alone is typically on the order of hundreds of nanoseconds (equivalent to a distance measurement resolution of hundreds of meters) and thus impractically latent for many depth-sensing applications.

US 2004/021057 A1 relates to a distance measuring device and photosensor circuit. By pulsing a light source such as an LED to illuminate an object and measuring the phase difference between the light reflected from the object and the original phase of the light source, the distance to an object may be determined.

US 2011/202310 A1 relates to a depth estimation apparatus and method. The depth estimation method includes grouping a plurality of frame signals generated by a depth pixel into a plurality of frame signal groups which are used to estimate a depth to an object without a depth estimation error caused by an omission of a frame signal. The grouping of the plurality of frame signals is based on whether an omitted frame signal exists in the plurality of frame signals and is based on a continuous pattern of the plurality of frame signals, and the depth to the object is estimated using each of the plurality of frame signal groups.

US 8 686 367 B2 relates to an apparatus including a photodiode, a first and second storage transistor, a first and second transfer transistor, and a first and second output transistor. The first transfer transistor selectively transfers a first portion of the image charge from the photodiode to the first storage transistor for storing over multiple accumulation periods. The first output transistor selectively transfers a first sum of the first portion of the image charge to a readout node. The second transfer transistor selectively transfers a second portion of the image charge from the photodiode to the second storage transistor for storing over the multiple accumulation periods. The second output transistor selectively transfers a second sum of the second portion of the image charge to the readout node.

US 2016/099283 A1 relates to a pixel cell including a charge accumulation region having a second doping polarity buried completely in a semiconductor substrate having a first doping polarity beneath a first surface. The charge accumulation region accumulates image charge in response to light directed through a second surface. A channel region is disposed in the semiconductor substrate between the first surface and the charge accumulation region. A variable resistance of the channel region is responsive to the image charge accumulated in the charge accumulation region. A center contact coupled to a central portion of the channel region through the first surface to provide a radial current path through the channel region between the central portion of the channel region and a periphery of the channel region around the charge accumulation region to the semiconductor substrate. A readout signal responsive to the image charge in the charge accumulation region is provided at the center contact.

Fossum Eric R et al.: "A Review of the Pinned Photodiode for CCD and CMOS Image Sensors", IEEE Journal pf the Electron Devices Society, IEEE, USA, vol. 2, no. 3, 1 May 2014, pages 33 to 43, reviews the development, physics, and technology of the pinned photodiode.

### TECHNICAL FIELD

The disclosure herein relates to solid-state light sensors that may be deployed in three-dimensional imagers or depth sensors.

### SUMMARY

The invention is defined as set out in the independent claims. Further embodiments are depicted in the dependent claims.

### DRAWINGS

The various embodiments disclosed herein are illustrated by way of example, and not by way of limitation, in the figures of the accompanying drawings and in which like reference numerals refer to similar elements and in which:
Figure 1 illustrates an embodiment of a depth sensor (or 3D sensor) having a light source and a low-latency, multi-photowell light sensor;
Figure 2 illustrates an embodiment, not covered by the invention, of the low-latency multi-photowell photodetector shown in Figure 1;
Figure 3 illustrates an exemplary detection cycle within the low-latency multi-well photodetector of Figure 2;
Figure 4 illustrates a photodiode reset sequence that may be executed after every detection cycle or every few detection cycles within the low-latency multi-well photodetector of Figure 2;
Figure 5 illustrates an embodiment of a low-latency multi-photowell photodetector having a JFET-based device that doubles as a multi-well photodiode and output transistor;
Figure 6 illustrates an exemplary operational sequence within the JFET-based photodetector of Figure 5;
Figure 7 illustrates exemplary top and cross-sectional views of a p-type JFET transistor stacked vertically over a photodiode as in the Figure 5 detector;
Figures 8 and 9 illustrate alternative JFET-based photodetector circuits;
Figure 10 illustrates an embodiment of an analog front end/time-to-digital converter (AFE/TDC) having parallel amplification paths with stepped-down gains to trigger count-latching operations within respective registers at respective photon detection counts; and
Figure 11 illustrates an alternative AFE/TDC embodiment in which a single amplifier stage outputs an amplified photodetector output signal to latch inputs of registers having respective, progressively higher latching thresholds.

### DETAILED DESCRIPTION

Light sensors having multi-carrier photowell depth and sub-nanosecond read-out latency (or latency not more than a few nanoseconds) are disclosed in various embodiments herein together with corresponding embodiments of analog front ends (AFEs) and time-to- digital converters (TDCs) that provide for rapid and/or resolute signal digitization. When deployed within a depth sensor or 3D sensor, the multi-photon sensitivity (i.e., multi-electron or multi-hole well depth) in combination with the low-latency readout and improved AFE/TDC enable dramatically improved depth sensing (higher sensitivity, finer resolution) relative to conventional avalanche-gain sensors.

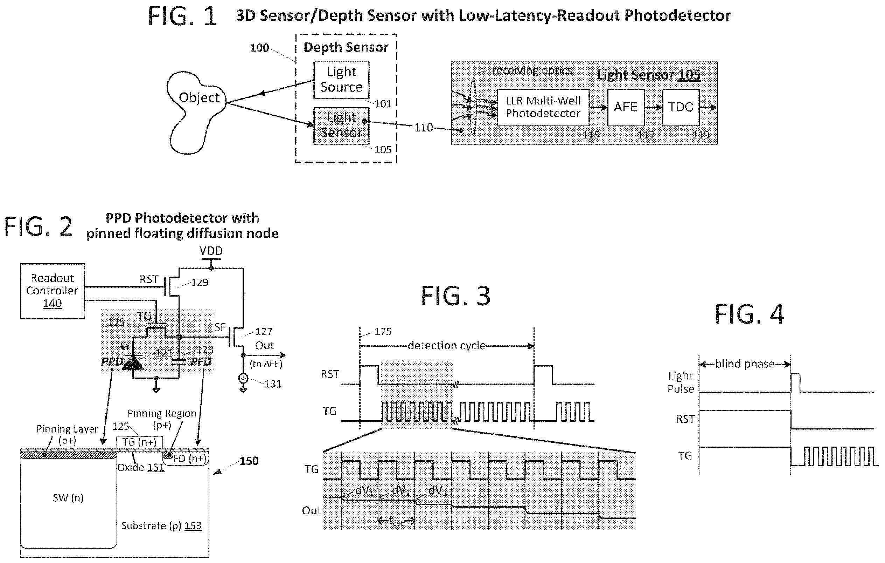

Figure 1 illustrates an embodiment of a depth sensor (or 3D sensor) 100 having a light source 101 and a low-latency, multi-photowell light sensor 105 - that is, a light sensor with a photowell capable of storing multiple photocarriers (in contrast to single photocarrier avalanche-gain sensors) and generating a sensor output indicative of photocarrier accumulation (and thus incident photon strikes) either immediately as incident photon strikes occur or within a few nanoseconds (or less than a nanosecond) of a readout pulse. Referring to detail view 110, for example, light sensor 105 includes optional receiving optics to focus inbound (reflected) light onto a low-latency-readout (LLR) multi-well photodetector 115 which in turn outputs a detection signal via analog front end (AFE) 117 to time-to-digital converter (TDC) 119. The TDC output is supplied to back-end processing logic (not specifically shown) within depth sensor 100 which finalizes and outputs measurement data.

Figure 2 illustrates an embodiment (not covered by the invention) of the low-latency multi-photowell photodetector of Figure 1, in this case having a pinned photodiode (PPD) 121 and pinned floating diffusion node (PFD) 123 interconnected by a gated channel (i.e., gated by transfer gate 125). A readout controller 140 asserts transfer-gate (TG) pulses at transfer gate 125 to form a charge-transfer channel between the PPD and PFD and thus transfer of photocharge accumulated within the photodiode to the pinned floating diffusion node for read-out via source-follower transistor 127. The pinning region within the floating diffusion counteracts TG pulse feedthrough to the floating diffusion node, avoiding the relatively long floating-diffusion settling time (delay before read-out) that plagues non-pinned floating diffusion structures and thus dramatically reduces the time between TG pulse assertion and settled output signal. In a number of embodiments, for example, the delay between TG pulse assertion and output signal settling (at the source terminal of transistor 127) is reduced from hundreds of nanoseconds to fewer than 100 nanoseconds and more generally fewer than 10 nanoseconds or five nanoseconds or less (e.g., 3, 2, or 1 nanoseconds or even sub-nanosecond intervals) and thereby reducing photodetector readout latency by two or more orders of magnitude. The pinned photodiode may be designed to have a photo-well of any practicable size (multi-photocarrier storage well, SW) and the floating diffusion node can likewise be sized to yield sufficiently high conversion gain (according to the ratio of PPD and PFD capacitance) and low input-referred read noise to enable photon-counting sensitivity. The source-follower transistor 127 is so named for its configuration within a source-follower circuit implemented by voltage-following action between the gate terminal (to which pinned floating diffusion node 123 is coupled) and source terminals of that transistor. More specifically, current source 131 establishes a constant bias current through transistor 127 to effect a steady-state gate-to-source voltage that causes the photodetector output at the source terminal of transistor 127 to follow the potential of the pinned floating diffusion node (at the gate of transistor 127) - that is, any change in the PFD potential will appear at the SF transistor source and thus in the signal output the AFE. Reset transistor 129 is provided to enable PFD and PPD reset, restoring the PFD node to VDD (in this example) when the readout controller asserts a reset pulse (RST) and restoring both the PFD and PPD storage nodes to VDD when the readout controller concurrently raises the RST and TG signals.

Still referring to Figure 2, the p+ pinning region in the n+ floating diffusion may be sized as necessary to mitigate TG pulse feedthrough caused by TG-FD capacitance coupling. Referring to physical cross-section 150 (showing pinning-layer and storage well (SW) components of the pinned photodiode together with pinning region and capacitive storage (FD) regions of the pinned floating diffusion node), the transfer gate 125 (e.g., implemented by doped polysilicon) is disposed over a surface oxide to enable formation of an enhancement channel within substrate 153 between the PPD and PFD.

Figure 3 illustrates an exemplary detection cycle within the low-latency multi-well photodetector of Figure 2. At detection-cycle commencement (150), the readout controller asserts a reset pulse to reset the floating diffusion node - to VDD in this example - and then outputs a train of TG pulses to iteratively sample the charge accumulation level within the pinned photodiode. Each TG pulse enables transfer of collected (generated) photocharge from the storage well of the photodiode to the pinned floating diffusion node (i.e., any charge collected by the PPD since the previous TG pulse assertion will be transferred to the PFD and thereby change the PFD potential), with any such charge transfer yielding an output voltage step having a magnitude (dV₁, dV₂, dV₃) according to the number of transferred photocarriers. Note that the floating diffusion reset operation is executed only at the beginning of the light-detection cycle to recover the output voltage to a relatively high value (reset value) - in contrast to a conventional CMOS image sensor that resets the floating diffusion (asserts a RST pulse) prior to every charge-transfer event (i.e., prior to every TG pulse).

Within a depth sensor or 3D sensor, the AFE and TDC may record the photodetector output signal magnitude and timing following each TG pulse to enable backend logic/computing circuitry to produce a time-of-flight-dependent depth measurement (e.g., ascertain a time at which the output signal falls below a detection threshold and apply that time in depth measurement computation). In general the detection resolution is constrained by the TG pulse cycle time (t_{cyc}), though the measurement generating logic may interpolate between voltage step-down events in successive pulse cycles to effect measurements with sub- t_{cyc} resolution (e.g., modeling a linear photon strike profile over the duration of the detection cycle and using the coefficients of that linear profile to estimate a threshold crossing within a given tcyc interval).

Figure 4 illustrates a photodiode reset sequence - simultaneous RST and TG signal assertion during an out-of-service "blind phase" - that may be executed after every detection cycle or every few detection cycles, the latter approach enabling an averaging of measurements captured along different photo-well fill points (i.e., potentially to correct for nonlinearity in charge transfer operations) and amortizing the blind-phase overhead over multiple detection cycles. In the example shown, a light pulse is emitted immediately upon conclusion of the photodiode reset operation (effectively an electrical shutter that may be used to clear thermally generated carriers and/or charge generated by ambient light) and TG pulse train output commences shortly or immediately thereafter (i.e., in accordance with a minimum depth measurement).

In alternative embodiments, transfer gate 125 and pinned floating diffusion node 123 may be omitted from the low-latency photodetector shown in Figure 2 so that pinned photodidode 121 drives the gate of source-follower transistor 127 continuously. Such an arrangement yields a relatively instantaneous output in response to photonic detection as no charge transfer operation is required and thus may be applied in time-critical systems having relaxed sensitivity requirements.

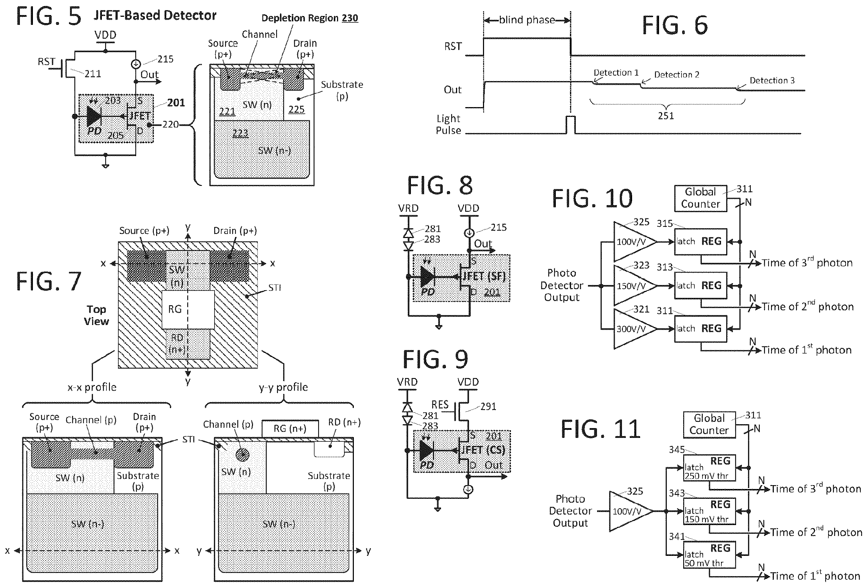

Figure 5 illustrates an alternative embodiment of the low-latency multi-photowell photodetector shown Figure 1, in this case having a JFET-based device 201 that doubles as a multi-well photodiode (PD) 203 and source-follower transistor 205 to drive downstream signal processing logic. As shown in cross-section view 220, the source and channel of a depletion-mode JFET are implemented over a dual-region n-doped storage well (i.e., having n-doped region 221 and less heavily n-doped region 223) while the transistor drain is implemented over the p-type substrate in which the dual-region storage well is formed. The p-n junction between the p-type substrate and n-type storage well effectively constitute a photodiode installation beneath the JFET (i.e., a stacked JFET/PD structure). From a functional perspective, the drain of the JFET is internally connected to the substrate and biased to VSS (connection not shown), while the source of the JFET is coupled to constant current source 215 (itself coupled between VDD and the JFET source terminal). As photon strikes yield electron-hole pairs within the silicon, electrons (photocharge) are collected by the storage well and accumulate in the more heavily n-doped region (221) surrounding the JFET channel - modulating the electrostatic potential of the storage well and thus modulating the width of the depletion region in the channel as shown by the dashed-line depletion profiles at 230, effectively changing the channel resistance. Because the current through the channel is held constant by current source 215, the voltage on the source of the JFET follows the potential of the storage well (i.e., when the detector is biased in the saturation region) and is thus changes in proportion to the number of absorbed photons.

The JFET-based detector of Figure 5 provides a number of advantages over pinned photodiode detection schemes. For one, no charge-transfer operation is required as absorbed photons yield instantaneous voltage change on the detector output, enabling higher temporal resolution and thus higher-precision depth measurement. The JFET-based detector may also exhibit higher conversion gain and lower input-referred readout noise than MOSFET-based detectors (e.g., pinned-photodiode-based detectors) due to a further reduced parasitic capacitance and voltage noise from the source follower, enabling single-photon sensitivity.

Figure 6 illustrates an exemplary operational sequence within the JFET-based photodetector of Figure 5. Initially an electrical shutter is applied during a blind phase by positively biasing (i.e., asserting RST to switch on) the reset gate - element 211 of Figure 5 - to clear (reset to VDD) the photodiode storage well. At conclusion of the blind phase, a light pulse is emitted to commence the depth sensing (and/or 3D imaging) operation. Thereafter, each photon strike yields a photo-electron capture within the storage well and thus a stepdown of the output voltage as shown at 251. The timing and magnitude of the output voltage change will be recorded by the subsequent readout electronics (AFE/TDC circuitry) to enable generation of depth/distance/proximity measurements within back-end processing logic.

Figure 7 illustrates exemplary top and cross-sectional views of a p-type JFET transistor stacked vertically over a photodiode as in the Figure 5 detector. In the embodiment shown, the JFET-based detector includes a pair of (p+)-type heavily-doped source and drain regions, an n-type doped storage well (SW) for collection and storage of photoelectrons, a p-type doped channel interconnecting the source and drain regions, and an oxide-filled isolation trench (e.g., implemented using shallow-trench-isolation (STI) techniques, implantation-based isolation, etc.) to isolate the source region from the p-type substrate. A reset transistor is physically coupled to the storage well n-type region to conduct reset operation to the storage well, where the reset drain is constantly biased to a positive voltage higher than the threshold voltage of the transistor (e.g. VDD) and the reset operation can be asserted by positively biasing the reset gate. In alternative embodiments, a JFET- based detector is implemented with an n-type channel, reversing the doping polarity in each region while maintaining the relative doping concentration.

Figures 8 and 9 illustrate alternative JFET-based photodetector circuits. In the Figure 8 embodiment, gateless reset is achieved using punch-through diodes 281, 283 - The punch-through diode forms a npn junction with the photodiode n-type doping well. It conducts reset operation for the photodiode by positively pulsing the reset drain n-well. Compared to the conventional reset transistor approach, it provides less parasitic capacitance between the reset gate and the voltage output node (e.g. photodiode or floating diffusion) and hence yielding higher conversion gain and lower input-referred read noise. In the Figure 9 embodiment (which may be implemented with gateless reset or with the gated reset arrangement shown in Figure 5), the JFET is biased to function as a common-source amplifier (instead of the common-drain source-follower arrangement shown in Figure 5) to boost the detector gain. More specifically, a constant current source is coupled between drain and VSS (which may be ground) to bias the JFET drain potential, while a resistance-control transistor 291 (RES) is coupled between the JFET source and VDD to bias the JFET source terminal.

As mentioned above, avalanche-gain photodetectors such as SPADs and SiPMs have only single-electron (photon) well capacity and thus saturate after each detected photon and require reset before the next detection. The limited capacity restricts the capabilities of the detector. For example, if the full-well capacity (FWC) is higher than one electron, as in the case of the pinned-photodiode and JFET-based photodetectors described above, light intensity information can be acquired during the detection cycle and used for more informative/descriptive measurement - for example, detecting reflectance coefficients and textures of sensed objects. More specifically, the pinned-photodiode and JFET-based photodetectors described herein may be implemented with well capacities well beyond a single photoelectron - for example, 2, 3, 5, 10, 100, 1000 or more photoelectron well-depths or more (or any well depth between those limits) and thus yield output signals that change progressively throughout/within a given light-detection cycle (e.g., as shown in Figures 3 and 6). In a number of embodiments, AFEs and TDCs capable of capturing the intra-detection-cycle arrival time and intensity information corresponding to successive photon reception events occurring prior to photodetector saturation (including events or sub-intervals in which more than one photoelectron is captured) are coupled with such multi-well low-latency photodetectors to enable high-speed readout of such intra-cycle information.

In a number of sensor system embodiments, a high-bandwidth, low-noise gain stage is implemented within the analog front end (AFE) to amplify the low-latency photodetector output signal and prepare the signal for the high-speed digitization, enabling high-sensitivity/high-resolution depth measurement that leverages the additional sensory data made available by the multi-carrier photowell. In general, the required AFE gain is application specific and depends on the conversion gain of the detector and the photowell depth. In applications requiring relatively low temporal resolution and high sensitivity (i.e., long-distance/high-spatial-resolution depth measurement) for example, low-latency CMOS photodetectors having extremely low read noise (e.g., CMOS photodetectors having a pinning region in the floating diffusion as discussed above) and pump-gate jots (i.e., as described in US App. 15/301,267) can be used. Charge transfer amplifiers (CTAs) can be used to readout these photodetectors (pixels). Stacked structures can also be used to increase the bandwidth of the in-pixel amplifier. For example, a cluster-parallel architecture can be implemented as explained in International application PCT/US17/22607. In any case, after amplification by the analog front end, the photodetector output signal can be buffered by one or more inverters (as necessary) and applied to a TDC (e.g., a counter and circuit to latch the counter output upon detecting an AFE output above a predetermined or programmed threshold).

Figure 10 illustrates an embodiment of an AFE/TDC having parallel amplification paths with stepped-down gains to trigger latching operations within respective registers - i.e., latching the output of a global counter 310 and thus a measure of time transpired - at respective photon detection counts. For example, when coupled between a photodetector having a 1mV/e- conversion gain and registers 311, 313, 315 having a 300mV trigger threshold (i.e., latch signal at or above 300mV will trigger a latching operation within the register, thereby recording the global count at the triggered point in time), the gains of amplifiers 321, 323, 325 are set to 300x (300volts per volt or 300V/V), 150x and 100x, respectively. By this operation, a single photon detection (collection of a single photoelectron within the photodiode storage well) will produce, via amplifier stage 321, a latch-triggering signal (300mV) at the input of latch 311 to capture the time of the detection event (i.e., latch the output of the global counter in response to the first photon detection). The lower gain levels within amplifier stages 323 and 325 will yield under-threshold output signals (150mV and 100mV) at the latch inputs of registers 313 and 315 so that those registers remain armed and available to latch subsequent global-count values. Accordingly, upon detection of a second photon, the photodetector output signal doubles from 1mV to 2mV, thus yielding a 300mV output from amplifier stage 323 to trigger a count-latching operation within register 313 to capture the time (global count) of the second photon detection event. The photodetector increments by another mV (to 3mV) upon detection of a third photon to yield a 300mV output from amplifier stage 325 and thus latch the global count (and time of third photon detection) within register 315. Additional AFE gain stages and TDC registers may be provided in alternative embodiments to generate TDC outputs (global count value capture) with respect to subsequent photon detection events up to the well depth (saturation level) of the photodetector. Also, light sensors having an array of photodetectors (pixels in an array) may include a corresponding array of the AFE/TDC unit shown in Figure 10 (a single global counter may be provided to yield the elapsed-time count for the entire array).

Figure 11 illustrates an alternative AFE/TDC embodiment in which a single amplifier stage outputs an amplified photodetector output signal to latch inputs of registers having respective and progressively higher latching thresholds. Continuing with the exemplary 1mV/e- conversion-gain photodetector, an amplifier stage 325 having a 100V/V gain drives the latch inputs of registers 341, 343 and 345, having respective 50mV, 150mV and 250mV latch-trigger thresholds. By this arrangement, a single photon detection will produce a 100mV amplifier output and thus trigger a count-latching operation within register 341 (i.e., the 100mV output from amplifier 325 exceeds the 50mV latching threshold of register 341, but not the 150mV and 250mV thresholds of registers 343 and 345). A second photon detection will latch the output of global counter 311 within register 343 (i.e., amplifier 325 will generate a 200mV output that exceeds the 150mV latching threshold of register 343) and a third photon detection will latch the global-count within register 345 (i.e., 300mV output from amplifier > 250mV latching threshold of register 345). As with the embodiment of Figure 10, additional TDC registers with progressively higher latching thresholds may be provided in alternative embodiments to generate TDC outputs (global count value capture) with respect to subsequent photon detection events up to the well depth (saturation level) of the photodetector. Also, light sensors having an array of photodetectors may include a corresponding array of the AFE/TDC unit shown in Figure 11 (though a single global counter may be provided to yield the elapsed-time count for the entire AFE/TDC array).

The AFE/TDC circuits illustrated in Figures 10 and 11 - the amplifier stage(s) in particular - may be implemented in a stacked process to increase the fill-factor of the photodetector IC and/or reduce the length (and thus the parasitic capacitance) of the photodetector output line (e.g., a column output line) to increase the bandwidth of the AFE/TDC circuitry. In such stacked multi-well (non-avalanche) depth-sensing sensor, the entirety or any portion of the readout circuitry (including AFE/TDC) may be Co-located on the same integrated circuit chip as the photodetector cell(s). Alternatively, the readout circuitry may be disposed in whole or part on a logic chip bonded or otherwise mounted in a stacked configuration with a sensor chip bearing the photodetector cells (e.g., wafer bonding of a first wafer containing readout circuitry with a second wafer containing photodetectors, followed by singulation into two-die stacks in which an exposed exterior surface of the photodetector chip constitutes a backside illumination surface).

The various detectors, readout circuitry and physical configurations disclosed herein may be described using computer aided design tools and expressed (or represented), as data and/or instructions embodied in various computer-readable media, in terms of their behavioral, register transfer, logic component, transistor, layout geometries, and/or other characteristics. Formats of files and other objects in which such circuit expressions may be implemented include, but are not limited to, formats supporting behavioral languages such as C, Verilog, and VHDL, formats supporting register level description languages like RTL, and formats supporting geometry description languages such as GDSII, GDSIII, GDSIV, CIF, MEBES and any other suitable formats and languages. Computer-readable media in which such formatted data and/or instructions may be embodied include, but are not limited to, computer storage media in various forms (e.g., optical, magnetic or semiconductor storage media, whether independently distributed in that manner, or stored "in situ" in an operating system).

When received within a computer system via one or more computer-readable media, such data and/or instruction-based expressions of the above described circuits can be processed by a processing entity (e.g., one or more processors) within the computer system in conjunction with execution of one or more other computer programs including, without limitation, net-list generation programs, place and route programs and the like, to generate a representation or image of a physical manifestation of such circuits. Such representation or image can thereafter be used in device fabrication, for example, by enabling generation of one or more masks that are used to form various components of the circuits in a device fabrication process.

In the foregoing description and in the accompanying drawings, specific terminology and drawing symbols have been set forth to provide a thorough understanding of the disclosed embodiments. In some instances, the terminology and symbols may imply details not required to practice those embodiments. For example, any of the specific threshold levels, amplification levels, conversion gains, component counts, interconnect topologies, sensor implementations, component elements and the like can be different from those described above in alternative embodiments. Signal paths depicted or described as individual signal lines may instead be implemented by multi-conductor signal buses and vice-versa and may include multiple conductors per conveyed signal (e.g., differential or pseudo-differential signaling). The term "coupled" is used herein to express a direct connection as well as a connection through one or more intervening functional components or structures. Device configuration or programming can include, for example and without limitation, loading a control value into a register or other storage circuit within an integrated circuit device in response to a host instruction (and thus controlling an operational aspect of the device and/or establishing a device configuration) or through a one-time programming operation (e.g., blowing fuses within a configuration circuit during device production), and/or connecting one or more selected pins or other contact structures of the device to reference voltage lines (also referred to as strapping) to establish a particular device configuration or operation aspect of the device (e.g., amplification factor, latching threshold, etc.). The terms "exemplary" and "embodiment" are used to express an example, not a preference or requirement. Also, the terms "may" and "can" are used interchangeably to denote optional (permissible) subject matter. The absence of either term should not be construed as meaning that a given feature or technique is required.

Various modifications and changes can be made to the embodiments presented herein without departing from the broader scope of the invention that is defined by the claims. Accordingly, the specification and drawings are to be regarded in an illustrative rather than a restrictive sense.

## Claims

1. A sensing device (100) comprising:
a light source (101) to emit light;
a light sensor (105) to detect reflection of the light emitted by the light source (101), the light sensor (105) having a photodetector (115) with a photocharge storage capacity in excess of one electron;
an output circuit (117) to generate an output signal that transitions between voltage levels in response to and within 100 nanoseconds of photonic detection, within the photodetector (115), of the reflection of the light emitted by the light source (101); and
a distance determination circuitry (119) to measure an elapsed time based on the output signal transition in response to the photonic detection and to determine, based on the elapsed time, a distance between the sensing device (100) and a surface that yielded the reflection of the light emitted by the light source,
wherein the photodetector comprises a photodiode having a photowell ;
**characterized in that** the output circuit comprises a junction field-effect-transistor (JFET) having a channel disposed adjacent the photowell of the photodiode.

2. The sensing device of claim 1 wherein the JFET comprises doped source and drain regions electrically exposed at a surface of a semiconductor substrate and interconnected by a conduction channel, and wherein the photodiode extends below the surface of the semiconductor substrate beneath conduction channel.

3. The sensing device of claim 1 or 2 wherein the photodiode comprises an n-doped region and a less heavily n-doped region that form a dual-region storage well beneath the JFET, wherein a dual-region storage well comprises a p-n junction for the JFET.

4. The sensing device of any one of claims 1 to 3 wherein the photodiode comprises a p-type substrate, the JFET includes a p-doped source, and the p-doped source is isolated from p-type substrate with an oxide-filled isolation trench.

5. The sensing device of any one of claims 1 to 4 wherein no charge-transfer operation is performed in the photodetector to generate the output signal via the output circuit.

6. The sensing device of any one of claims 1 to 5 wherein the sensing device is a non-avalanche depth sensor.

7. The sensing device of any one of claims 1 to 6 wherein the output circuit (117) to generate the output signal comprises circuitry to generate the output signal within 5 nanoseconds of photonic detection of the reflection of the light emitted by the light source (101).

8. The sensing device of any one of claims 1 to 7 wherein the distance determination circuitry (119) comprises a counter (311) that increments or decrements a count output over time in response to transitions of a clock signal and circuit to latch the counter output in response to the transition between voltage levels in the output signal.

9. A method of operation within a sensing device, the method comprising:
emitting light from the sensing device;
detecting reflection of the emitted light within a photodetector having a photocharge storage capacity in excess of one electron;
generating an output signal that transitions between voltage levels in response to and within 100 nanoseconds of detection of the reflection of the emitted light within the photodetector;
measuring an elapsed time based on the output signal transition in response to the photonic detection;
determining, based on the elapsed time, a distance between the sensing device and a surface that yielded the reflection of the light emitted by the light source,
wherein detecting reflection of the emitted light within the photodetector (115) comprises accumulating photocharge within a photodiode disposed adjacent a channel of a junction field-effect-transistor (JFET), and
wherein generating the output signal comprises generating the output signal at a terminal of the JFET coupled to the channel, the output signal having a voltage level according to amount of photocharge accumulated within the photodiode.

10. The method of claim 9, wherein no charge-transfer operation is performed in the photodetector to generate the output signal via the output circuit.

11. The method of claim 9 or 10, wherein the output circuit (117) generates the output signal within 10 nanoseconds of photonic detection of the reflection of the emitted light.

12. The method of claim 9 or 11, wherein the output circuit (117) generates the output signal within 5 nanoseconds of photonic detection of the reflection of the emitted light.

13. The method of any one of claims 9 to 12, further comprising the sensing device:
performing a depth sensing operation after a blind phase; and
determining a stepdown of voltage in the output signal during the depth sensing operation.

14. The method of claim 13, further comprising the sensing device performing a photodiode reset operation during the blind phase.

15. The method of claim 9 or 11, further comprising the sensing device:
generating, via a counter, a count output over time in response to transitions of a clock signal and circuit to latch the counter output in response to the transition between voltage levels in the output signal.

## Patentansprüche

1. Eine Erfassungsvorrichtung (100), umfassend:
eine Lichtquelle (101) zum Emittieren von Licht;
einen Lichtsensor (105) zum Detektieren von Reflexion des von der Lichtquelle (101) emittierten Lichts, wobei der Lichtsensor (105) einen Photodetektor (115) mit einer Photoladungsspeicherkapazität von mehr als einem Elektron hat;
eine Ausgangsschaltung (117) zum Erzeugen eines Ausgangssignals, das als Reaktion auf und innerhalb von 100 Nanosekunden nach photonischer Detektion, innerhalb des Photodetektors (115), der Reflexion des von der Lichtquelle (101) emittierten Lichts zwischen Spannungspegeln übergeht; und
eine Abstandsbestimmungsschaltung (119) zum Messen einer verstrichenen Zeit basierend auf dem Ausgangssignalübergang als Reaktion auf die photonische Detektion und zum Bestimmen, basierend auf der verstrichenen Zeit, eines Abstands zwischen der Erfassungsvorrichtung (100) und einer Oberfläche, die die Reflexion des von der Lichtquelle emittierten Lichts ergab, wobei der Photodetektor eine Photodiode mit einer Photowanne (photowell) umfasst;
**dadurch gekennzeichnet, dass** die Ausgangsschaltung einen Sperrschicht-Feldeffekttransistor (JFET) mit einem Kanal umfasst, der angrenzend an die Photowanne der Photodiode angeordnet ist.

2. Die Erfassungsvorrichtung nach Anspruch 1, wobei der JFET dotierte Source- und Drain-Regionen umfasst, die an einer Oberfläche eines Halbleitersubstrats elektrisch freiliegen und durch einen Leitungskanal miteinander verbunden sind, und wobei sich die Photodiode unter der Oberfläche des Halbleitersubstrats unter dem Leitungskanal erstreckt.

3. Die Erfassungsvorrichtung nach Anspruch 1 oder 2, wobei die Photodiode eine n-dotierte Region und eine weniger stark n-dotierte Region umfasst, die eine Dual-Region-Speicherwanne unter dem JFET bilden, wobei eine Dual-Region-Speicherwanne einen p-n-Übergang für den JFET umfasst.

4. Die Erfassungsvorrichtung nach einem der Ansprüche 1 bis 3, wobei die Photodiode ein p-Typ-Substrat umfasst, der JFET eine p-dotierte Source beinhaltet und die p-dotierte Source von dem p-Typ-Substrat mit einem oxidgefüllten Isolationsgraben isoliert ist.

5. Die Erfassungsvorrichtung nach einem der Ansprüche 1 bis 4, wobei kein Ladungstransfervorgang in dem Photodetektor durchgeführt wird, um das Ausgangssignal über die Ausgangsschaltung zu erzeugen.

6. Die Erfassungsvorrichtung nach einem der Ansprüche 1 bis 5, wobei die Erfassungsvorrichtung ein Nicht-Lawinentiefensensor ist.

7. Die Erfassungsvorrichtung nach einem der Ansprüche 1 bis 6, wobei die Ausgangsschaltung (117) zum Erzeugen des Ausgangssignals eine Schaltung zum Erzeugen des Ausgangssignals innerhalb von 5 Nanosekunden nach photonischer Detektion der Reflexion des von der Lichtquelle (101) emittierten Lichts umfasst.

8. Die Erfassungsvorrichtung nach einem der Ansprüche 1 bis 7, wobei die Abstandsbestimmungsschaltung (119) einen Zähler (311) umfasst, der eine Zählausgabe über die Zeit als Reaktion auf Übergänge eines Taktsignals inkrementiert oder dekrementiert, und eine Schaltung zum Zwischenspeichern der Zählerausgabe als Reaktion auf den Übergang zwischen Spannungspegeln in dem Ausgangssignal.

9. Ein Verfahren zum Betrieb innerhalb einer Erfassungsvorrichtung, wobei das Verfahren umfasst:
Emittieren von Licht von der Erfassungsvorrichtung;
Detektieren von Reflexion des emittierten Lichts innerhalb eines Photodetektors mit einer Photoladungsspeicherkapazität von mehr als einem Elektron;
Erzeugen eines Ausgangssignals, das als Reaktion auf und innerhalb von 100 Nanosekunden nach Detektion der Reflexion des emittierten Lichts innerhalb des Photodetektors zwischen Spannungspegeln übergeht;
Messen einer verstrichenen Zeit basierend auf dem Ausgangssignalübergang als Reaktion auf die photonische Detektion;
Bestimmen, basierend auf der verstrichenen Zeit, eines Abstands zwischen der Erfassungsvorrichtung und einer Oberfläche, die die Reflexion des von der Lichtquelle emittierten Lichts ergab, wobei das Detektieren von Reflexion des emittierten Lichts innerhalb des Photodetektors (115) das Akkumulieren von Photoladung innerhalb einer Photodiode umfasst, die angrenzend an einen Kanal eines Sperrschicht-Feldeffekttransistors (JFET) angeordnet ist, und
wobei das Erzeugen des Ausgangssignals das Erzeugen des Ausgangssignals an einem Anschluss des JFET umfasst, der mit dem Kanal gekoppelt ist, wobei das Ausgangssignal einen Spannungspegel gemäß der Menge an Photoladung hat, die innerhalb der Photodiode akkumuliert ist.

10. Das Verfahren nach Anspruch 9, wobei kein Ladungstransfervorgang in dem Photodetektor durchgeführt wird, um das Ausgangssignal über die Ausgangsschaltung zu erzeugen.

11. Das Verfahren nach Anspruch 9 oder 10, wobei die Ausgangsschaltung (117) das Ausgangssignal innerhalb von 10 Nanosekunden nach photonischer Detektion der Reflexion des emittierten Lichts erzeugt.

12. Das Verfahren nach Anspruch 9 oder 11, wobei die Ausgangsschaltung (117) das Ausgangssignal innerhalb von 5 Nanosekunden nach photonischer Detektion der Reflexion des emittierten Lichts erzeugt.

13. Das Verfahren nach einem der Ansprüche 9 bis 12, ferner umfassend, dass die Erfassungsvorrichtung:
einen Tiefenerfassungsvorgang nach einer Blindphase durchführt; und
einen Spannungsabfall in dem Ausgangssignal während des Tiefenerfassungsvorgangs bestimmt.

14. Das Verfahren nach Anspruch 13, ferner umfassend, dass die Erfassungsvorrichtung einen Photodioden-Rücksetzvorgang während der Blindphase durchführt.

15. Das Verfahren nach Anspruch 9 oder 11, ferner umfassend, dass die Erfassungsvorrichtung:
über einen Zähler eine Zählausgabe über die Zeit als Reaktion auf Übergänge eines Taktsignals erzeugt und eine Schaltung zum Zwischenspeichern der Zählerausgabe als Reaktion auf den Übergang zwischen Spannungspegeln in dem Ausgangssignal.

## Revendications

1. Un dispositif de détection (100) comprenant :
une source de lumière (101) pour émettre de la lumière ;
un capteur de lumière (105) pour détecter la réflexion de la lumière émise par la source de lumière (101), le capteur de lumière (105) possédant un photodétecteur (115) avec une capacité de stockage de photocharges qui est supérieure à un seul électron ;
un circuit de sortie (117) pour générer un signal de sortie qui opère une transition entre des niveaux de tension en réponse à, et dans les 100 nanosecondes qui suivent, une détection photonique, au sein du photodétecteur (115), de la réflexion de la lumière émise par la source de lumière (101) ; et
une circuiterie de détermination de distance (119) pour mesurer un temps écoulé sur la base de la transition du signal de sortie en réponse à la détection photonique et pour déterminer, sur la base du temps écoulé, une distance entre le dispositif de détection (100) et une surface qui a produit la réflexion de la lumière émise par la source de lumière,
dans lequel le photodétecteur comprend une photodiode avec un photopuits ;
**caractérisé en ce que** le circuit de sortie comprend un transistor à effet de champ à jonction (JFET) avec un canal disposé adjacent au photopuits de la photodiode.

2. Le dispositif de détection de la revendication 1 dans lequel le JFET comprend des régions de source et de drain dopées électriquement exposées au niveau d'une surface d'un substrat semi-conducteur et interconnectées par un canal de conduction, et dans lequel la photodiode s'étend sous la surface du substrat semi-conducteur au-dessous du canal de conduction.

3. Le dispositif de détection de la revendication 1 ou 2 dans lequel la photodiode comprend une région dopée *n* et une région moins fortement dopée *n* qui forment un puits de stockage à double région au-dessous du JFET, un puits de stockage à double région comprenant une jonction p-n pour le JFET.

4. Le dispositif de détection de l'une des revendications 1 à 3 dans lequel la photodiode comprend un substrat de type *p*, le JFET comprend une source dopée *p*, et la source dopée *p* est isolée du substrat de type *p* par une tranchée d'isolation remplie d'oxyde.

5. Le dispositif de détection de l'une des revendications 1 à 4 dans lequel aucune opération de transfert de charge n'est effectuée dans le photodétecteur pour générer le signal de sortie via le circuit de sortie.

6. Le dispositif de détection de l'une des revendications 1 à 5 dans lequel le dispositif de détection est un capteur de profondeur qui n'est pas à avalanche.

7. Le dispositif de détection de l'une des revendications 1 à 6 dans lequel le circuit de sortie (117) pour générer le signal de sortie comprend une circuiterie pour générer le signal de sortie dans les 5 nanosecondes de la détection photonique de la réflexion de la lumière émise par la source de lumière (101).

8. Le dispositif de détection de l'une des revendications 1 à 7 dans lequel la circuiterie de détermination de distance (119) comprend un compteur (311) qui incrémente ou décrémente dans le temps une sortie de compte en réponse à des transitions d'un signal d'horloge, et un circuit pour verrouiller la sortie de compteur en réponse à la transition entre niveaux de tension dans le signal de sortie.

9. Un procédé pour faire fonctionner un dispositif de détection, le procédé comprenant :
l'émission de lumière à partir du dispositif de détection ;
la détection de la réflexion de la lumière émise au sein d'un photodétecteur ayant une capacité de stockage de photocharges qui est supérieure à un seul électron ;
la génération d'un signal de sortie qui opère une transition entre des niveaux de tension en réponse à, et dans les 100 nanosecondes qui suivent, une détection de la réflexion de la lumière émise au sein du photodétecteur ;
la mesure d'un temps écoulé sur la base de la transition du signal de sortie en réponse à la détection photonique ;
la détermination, sur la base du temps écoulé, d'une distance entre le dispositif de détection et une surface qui a produit la réflexion de la lumière émise par la source de lumière,
dans lequel la détection de la réflexion de la lumière émise au sein du photodétecteur (115) comprend l'accumulation de photocharges avec une photodiode disposée adjacente à un canal d'un transistor à effet de champ à jonction (JFET), et
dans lequel la génération du signal de sortie comprend la génération du signal de sortie sur une borne du JFET couplée au canal, le signal de sortie ayant un niveau de tension fonction de la quantité de photocharges accumulées au sein de la photodiode.

10. Le procédé de la revendication 9, dans lequel aucune opération de transfert de charge n'est effectuée dans le photodétecteur pour générer le signal de sortie via le circuit de sortie.

11. Le procédé de la revendication 9 ou 10, dans lequel le circuit de sortie (117) génère le signal de sortie dans les 10 nanosecondes de la détection photonique de la réflexion de la lumière émise.

12. Le procédé de la revendication 9 ou 11, dans lequel le circuit de sortie (117) génère le signal de sortie dans les 5 nanosecondes de la détection photonique de la réflexion de la lumière émise.

13. Le procédé de l'une des revendications 9 à 12, comprenant en outre, par le dispositif de détection :
l'exécution d'une opération de détection de profondeur après une phase aveugle ; et
la détermination d'une décrémentation de tension dans le signal de sortie pendant l'opération de détection de profondeur.

14. Le procédé de la revendication 13, comprenant en outre l'exécution par le dispositif de détection d'une opération de remise à zéro de la photodiode pendant la phase aveugle.

15. Le procédé de la revendication 9 ou 11, comprenant en outre, par le dispositif de détection :
la génération, via un compteur, d'une sortie de compte dans le temps en réponse à des transitions d'un signal d'horloge et un circuit pour verrouiller la sortie de compteur en réponse à la transition entre niveaux de tension dans le signal de sortie.
